# EUROPEAN PATENT APPLICATION

(11) **EP 1 119 042 A2**
(43) Date of publication of application: **25.07.2001**
(21) Application number: 01201322.3
(22) Date of filing: 20.08.1993
(51) Int. Cl.: H01L 21/768, H01L 21/3105

(54) **Planar integrated circuit**

(30) Priority: 21.08.1992 US 934172
(62) Divisional of application: 93306617.7
(71) Applicant: STMicroelectronics, Inc., Carrollton, TX 75006-5039 (US)
(72) Inventor: Chan, Tsiu Chiu, Dallas County, Texas 75006 (US); Bryant, Frank Randolph, Denton, Denton County, Texas 76201 (US)
(74) Representative: Driver, Virginia Rozanne

(57) **Abstract**

A method is provided for a planar surface of a semiconductor integrated circuit, and an integrated circuit formed according to the same. A gate electrode is formed over a substrate having source/drain regions adjacent to the gate electrode and in the substrate. A silicon dioxide layer is formed over the gate electrode and a portion of the substrate not covered by the gate electrode. A first phosphorous doped spin-on-glass layer is formed over the silicon dioxide layer, wherein the spin-on-glass is doped to a concentration sufficient to facilitate gettering of charge mobile ions. An opening is then formed in the spin-on-glass layer and the silicon dioxide layer exposing a portion of the source drain region.

## Description

The present invention relates generally to semiconductor integrated circuit processing, and more specifically to a planarization technique suitable for use in the submicron technology.

The manufacturing costs of integrated circuits are largely dependent upon the chip area required to implement desired functions. The chip area, in turn, is defined by the geometries and sizes of the active components such as gate electrodes in metal-oxide-semiconductor (MOS) technology, and diffused regions such as MOS source and drain regions and bipolar emitters and base regions. These geometries and sizes are often dependent upon the photolithographic resolution available for the particular manufacturing facility. The goal of photolithography in establishing the horizontal dimensions of the various devices and circuits is to create a pattern which meets design requirements as well as to correctly align the circuit pattern on the surface of the wafer. As line widths shrink smaller and smaller in submicron photolithography, the process to print lines and contact holes in photoresist becomes increasingly more difficult.

With circuit advancement to the very-large-scale integration (VLSI) levels, more and more layers are added to the surface of the wafer. These additional layers in turn create more steps on the wafer surface. The resolution of small image sizes in photolithography thus becomes more difficult over the additional steps due to light reflection and the thinning of the photoresists over the steps. Planarization techniques are generally incorporated to offset the effects of a varied topography.

Many different planarization techniques have been used in the past, each with its own disadvantages. Multilayer photoresist processes have been used to create the desired images. The particular photoresist process depends upon the severity of the topography and the size of the desired images. These processes however, take longer and require more yield-limiting steps. Polyimides and reflow glass layers are used to planarize the surface of the wafer. Polyimides can be spun onto the wafer like the photoresist materials. After application, the polyimide is covered with a hard layer and patterned like the photoresists. Reflow glass layers are generally doped with boron or phosphorous or both to lower the temperature at which the glass layer will flow. While these layers achieve more planarization than previous methods, additional planarization is still required as the device geometries continue to shrink.

Spin-on-glass (SOG) is also a hard planarizing layer which is a mixture of silicon dioxide in a solvent that quickly evaporates. There may be carbon in the SOG to reduce the SOG's susceptibility to cracking after it is baked. SOG, by itself, however, is unable to prevent mobile ionic contaminants from travelling through the layer and into the devices or wafer surface below the SOG.

It is therefore an object of this invention to provide a method of forming a planarizing layer which is capable of preventing mobile ionic contaminants from traveling through the planarizing layer and into the underlying layers.

It is a further object of this invention to provide such a method which utilizes a doped spin-on-glass insulating layer.

It is a further object of this invention to provide such a method which utilizes conventional process flows.

Other objects and advantages of the invention will be apparent to those of ordinary skill in the art having reference to the following specification together with the drawings.

The invention may be incorporated into a method for forming a semiconductor device structure, and the semiconductor device structure formed thereby. A conductive structure is formed on the integrated circuit such as a gate electrode having source/drain regions in the substrate. An insulating layer, such as silicon dioxide, is formed over the conductive structure and a portion of the integrated circuit not covered by the conductive structure. A planar doped spin-on-glass layer is then formed over the insulating layer, wherein the spin-on-glass is doped to a concentration sufficient to prevent gettering of charge mobile ions.

The novel features believed characteristic of the invention are set forth in the appended claims. The invention itself, however, as well as a preferred mode of use, and further objects and advantages thereof, will best be understood by reference to the following detailed description of illustrative embodiments when read in conjunction with the accompanying drawings, wherein:

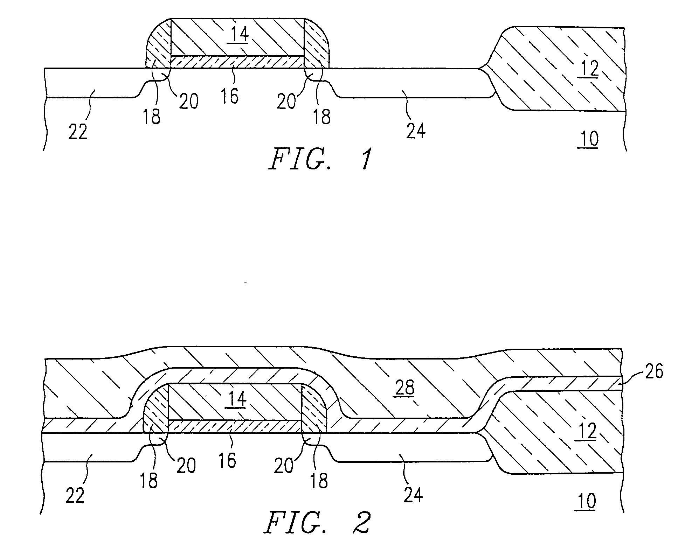

**Figures 1-2** are cross sectional views of the fabrication of a semiconductor integrated circuit according to the present invention.

The process steps and structures described below do not form a complete process flow for manufacturing integrated circuits. The present invention can be practiced in conjunction with integrated circuit fabrication techniques currently used in the art, and only so much of the commonly practiced process steps are included as are necessary for an understanding of the present invention. The figures representing cross-sections of portions of an integrated circuit during fabrication are not drawn to scale, but instead are drawn so as to illustrate the important features of the invention.

Referring to **Figure 1,** an integrated circuit is to be formed on a silicon substrate 10. A field oxide region 12 is formed in an area on the substrate as known in the art to separate active areas. A conductive structure such as a transistor is formed over a portion of the substrate 10. The transistor comprises gate electrode 14, preferably a doped polysilicon, which is formed over a gate oxide 16 as known in the art. The transistor typically also comprises oxide spacers 18 formed adjacent to the gate oxide 16 and gate electrode 14. Lightly doped source and drain regions 20 and heavily doped source and drain regions 22, 24 are formed in the substrate adjacent to the gate electrode, also by conventional methods.

Referring to **Figure 2,** an insulating layer 26, such as silicon dioxide is formed over a portion of the integrated circuit including the conductive structure. The silicon dioxide layer 26 is formed to prevent counterdoping between, for example, the source/drain regions 22, 24 and overlying layers subsequently formed. Layer 26 typically has a thickness of between approximately 100 to 2000 angstroms. Layer 26 may also be lightly doped to improve its protective and flow characteristics.

A planar spin-on-glass layer 28 is then deposited over the insulating layer 26 to a depth of between approximately 2000 to 8000 angstroms. The difference between the prior art and the present invention is that the SOG is now doped in the present invention, preferably with phosphorous, to a concentration sufficient to allow gettering of charge mobile ions. The dopant concentration is preferably between approximately 4 to 7 percent. For example, sodium molecules will not move through the SOG and penetrate the silicon dioxide layer 26 and silicon substrate 10. Instead, the contaminating ions will attach to the phosphorous in the SOG and be prevented from changing device characteristics. The SOG layer 28 may be cured to increase the layer's protective characteristics. The SOG is preferably cured at or below atmospheric pressure to enhance solvent outgassing. In addition, the temperature at which the SOG is cured will ramped up to between approximately 500 to 800° C. For example, the temperature may begin at a lower temperature to drive out the solvent molecules and be increased to a higher temperature to density the SOG. The doped SOG thus will planarize the surface of the wafer before a contact opening is formed while preventing contaminating ions from moving through the layer. The doped SOG will be particularly useful in the submicron regime where device size is decreasing and device performance is critical.

Alternatively, an etchback of the SOG layer 28 may be done before or after the curing process. A second layer of SOG may be formed to further planarize the surface of the wafer. The second layer, if formed, may also be doped and cured. Other uses of the doped SOG layer will become apparent to those skilled in the art. For example, the doped SOG layer may be formed between different polysilicon layers. Again, the doped SOG will planarize the surface of the wafer and allow gettering of the charge mobile ions.

While the invention has been particularly shown and described with reference to a preferred embodiment, it will be understood by those skilled in the art that various changes in form and detail may be made therein without departing from the spirit and scope of the invention.

## Claims

1. A structure consisting of a portion of an integrated circuit, comprising;
a conductive structure disposed over a portion of the integrated circuit;
an insulating layer (26) disposed over the conductive structure and a portion of the integrated circuit not covered by the conductive structure;
a first planar, spin-on-glass layer (28) disposed over the insulating layer (26), wherein the spin-on-glass is doped to a concentration of between 4 to 7 percent to facilitate gettering of charge mobile ions; and
a contact opening formed in the spin-on-glass layer and the insulating layer down to a portion of the conductive structure.

2. The structure of claim 1, wherein the conductive structure comprises a transistor gate having a gate electrode (14) disposed over a substrate (10) and a source/drain region (22,24) adjacent to the gate electrode (14) and in the substrate (10).

3. The structure of claim 1, wherein the insulating layer (26) comprises silicon dioxide.

4. The structure of claim 1, wherein the insulating layer (26) has a thickness of 100 to 2000 angstroms.

5. The structure of claim 1, wherein the first spin-on glass layer (28) is cured.

6. The structure of claim 5 wherein the first spin-on glass layer has been cured during a ramp up in temperature to between about 500°C and 800°C.

7. The structure of claim 1, further comprising:
a second planar, spin-on-glass layer disposed over the first spin-on-glass layer (26), wherein the second spin-on-glass is doped to a concentration of between 4 to 7 percent to facilitate getting of charge mobile ions.

8. The structure according to any preceding claim wherein the first planar spin-on-glass layer has a thickness between 2000 to 8000Å.

9. The structure according to any preceding claim wherein the insulating layer is doped with phosphorous.

10. The structure according to claim 2 wherein the contact opening exposes a portion of the source drain region.
